# EUROPEAN PATENT APPLICATION

(11) **EP 4 811 430 A1**
(43) Date of publication of application: **23.09.2026**
(21) Application number: 24890414.6
(22) Date of filing: 16.10.2024
(51) Int. Cl.: H01L 23/48, H01L 23/49

(54) **POWER SEMICONDUCTOR DEVICE, VEHICLE-MOUNTED CHARGER AND VEHICLE**

(30) Priority: 17.11.2023 CN 202323125650 U
(71) Applicant: BYD Company Limited, Shenzhen, Guangdong 518118 (CN)
(72) Inventor: XU, Xingfa, Shenzhen, Guangdong 518118 (CN); YANG, Shiqing, Shenzhen, Guangdong 518118 (CN)
(74) Representative: Mathys & Squire
(86) International application number: PCT/CN2024/125225
(87) International publication number: WO 2025/103056

(57) **Abstract**

A vehicle is provided with a vehicle-mounted charger. The vehicle-mounted charger is provided with a power semiconductor device. The power semiconductor device includes: a substrate, a first signal pin, and a plurality of power pins; and the first signal pin and the power pins are electrically connected to the substrate, where the plurality of power pins are disposed on the same side surface of the substrate, and the first signal pin and the power pins are disposed on different side surfaces of the substrate.

## Description

### CROSS-REFERENCE TO RELATED APPLICATIONS

This application claims priority to Chinese Patent Application No. 202323125650.2, filed Nov. 17, 2023 and entitled "POWER SEMICONDUCTOR DEVICE, VEHICLE-MOUNTED CHARGER, AND VEHICLE", which is incorporated herein by reference in its entirety for all purposes.

### TECHNICAL FIELD

This application relates to the technical field of semiconductors, and more specifically, to a power semiconductor device, a vehicle-mounted charger, and a vehicle.

### BACKGROUND

A power semiconductor device, also referred to as a power electronic device or a power device, is a basic component in the field of power electronics and can implement electric energy conversion and circuit control. In a circuit, the power semiconductor device is mainly used for power conversion, power amplification, power switching, circuit protection, inverting (direct current to alternating current), rectification (alternating current to direct current), or the like. Power semiconductor devices can be classified into semi-controlled, fully-controlled, or uncontrollable devices. A thyristor is a semi-controlled device with the highest withstanding voltage and current capacity among the devices. A power diode is an uncontrollable device with a simple structure, a simple principle and reliable operation. In addition, power semiconductor devices can alternatively be classified into voltage-driven and current-driven devices, where GTO and GTR are current-driven devices, and IGBT and power MOSFET are voltage-driven devices.

In related technologies, in a power semiconductor device, power pins are distributed on different side surfaces of a substrate, and the power pins and signal pins or a part of the signal pins are distributed on the same side surface, so that a power trace and a signal trace cross or are relatively close to each other, resulting in mutual interference between the power trace and the signal trace.

### SUMMARY

This application is proposed to resolve at least one of foregoing problems. According to one aspect of this application, a power semiconductor device is proposed. The power semiconductor device includes: a substrate, a first signal pin, and a plurality of power pins, wherein the first signal pin and the power pin are electrically connected to the substrate, the plurality of power pins are disposed on the same side surface of the substrate, and the first signal pin and the power pins are disposed on different side surfaces of the substrate.

In an embodiment of this application, the plurality of power pins are disposed on a first side surface of the substrate, the first signal pin is disposed on a second side surface of the substrate, and the first side surface is disposed adjacent or opposite to the second side surface.

In an embodiment of this application, a plurality of first signal pins are included, and the plurality of first signal pins are disposed on at least two side surfaces of the substrate.

In an embodiment of this application, the plurality of power pins are disposed on the first side surface of the substrate; and a part of the first signal pins are disposed on the second side surface of the substrate, and the remaining part of the first signal pins are disposed on a third side surface of the substrate, wherein the second side surface and the third side surface are disposed adjacent to the first side surface, or the second side surface is disposed adjacent to the first side surface and the third side surface is disposed opposite to the first side surface.

In an embodiment of this application, the plurality of power pins are disposed on the first side surface of the substrate; and a first part of the first signal pins are disposed on the second side surface of the substrate, a second part of the first signal pins are disposed on the third side surface of the substrate, and the remaining part of the first signal pins are disposed on a fourth side surface of the substrate, wherein the second side surface and the third side surface are disposed adjacent to the first side surface, and the fourth side surface is disposed opposite to the first side surface.

In an embodiment of this application, the power semiconductor device further includes a temperature sensor, and the temperature sensor is disposed on the substrate.

In an embodiment of this application, the temperature sensor includes a first thermistor and/or a second thermistor, two ends of the first thermistor are respectively electrically connected to second signal pins, one end of the second thermistor is electrically connected to a third signal pin, and the other end of the second thermistor is electrically connected to one of the power pins.

In an embodiment of this application, the second signal pins and the power pins are disposed on different side surfaces of the substrate.

In an embodiment of this application, the second signal pins and the first signal pins are disposed on different side surfaces of the substrate; or the second signal pins and at least a part of the first signal pins are disposed on the same side surface of the substrate.

In an embodiment of this application, the third signal pin and the power pins are disposed on the same side surface of the substrate.

In an embodiment of this application, the plurality of power pins and the third signal pin are disposed on the first side surface of the substrate, the first signal pins and the second signal pins are disposed on the second side surface of the substrate, and the first side surface is disposed adjacent or opposite to the second side surface.

In an embodiment of this application, the plurality of power pins and the third signal pin are disposed on the same side surface of the substrate; and a plurality of first signal pins are included, the plurality of first signal pins are disposed on at least two side surfaces of the substrate, and the second signal pins are disposed on at least one side surface on which the first signal pin is provided.

In an embodiment of this application, the plurality of power pins and the third signal pin are disposed on the first side surface of the substrate; a part of the first signal pins are disposed on the second side surface of the substrate, and the remaining part of the first signal pins are disposed on the third side surface of the substrate; and the third signal pin is disposed on the second side surface or the third side surface, wherein the second side surface and the third side surface are disposed adjacent to the first side surface, or the second side surface is disposed adjacent to the first side surface and the third side surface is disposed opposite to the first side surface.

In an embodiment of this application, the plurality of power pins and the third signal pin are disposed on the first side surface of the substrate; a first part of the first signal pins are disposed on the second side surface of the substrate, a second part of the first signal pins are disposed on the third side surface of the substrate, and the remaining part of the first signal pins are disposed on the fourth side surface of the substrate; and the second signal pins are disposed on the fourth side surface, wherein the second side surface and the third side surface are disposed adjacent to the first side surface, and the fourth side surface is disposed opposite to the first side surface.

In an embodiment of this application, the power semiconductor device includes any one of the following: a diode, a thyristor, a metal-oxide-semiconductor field effect transistor, an insulated-gate bipolar transistor, silicon carbide, or gallium nitride.

In an embodiment of this application, the power pin and the first signal pin include at least one of the following: an SOP surface-mount pin, a DIP through-hole pin, a PLCC through-hole pin, and an SOJ surface-mount pin.

In an embodiment of this application, the power semiconductor device further includes a housing and a wafer, the wafer is disposed on the substrate, and the housing encapsulates the wafer and the substrate.

According to another aspect of this application, a vehicle-mounted charger is proposed, including the power semiconductor device according to any one of the foregoing.

According to yet another aspect of this application, a vehicle is proposed, including the foregoing vehicle-mounted charger.

In the power semiconductor device, the vehicle-mounted charger, and the vehicle according to the embodiments of this application, the plurality of power pins are disposed on the same side surface of the substrate, and the first signal pins and the power pins are disposed on the different side surfaces of the substrate, so that a power trace and a first-type signal trace can be separated, avoiding crossed traces, and there is no mutual interference between the power trace and the first-type signal trace.

### BRIEF DESCRIPTION OF DRAWINGS

The foregoing and other objects, features, and advantages of this application will become more apparent from a more detailed description of embodiments of this application in conjunction with accompanying drawings. The accompanying drawings are intended to provide a further understanding of the embodiments of this application and constitute a part of this specification. Together with the embodiments of this application, they are used to explain this application, but do not constitute a limitation of this application. In the accompanying drawings, same reference numerals generally represent same components or steps.
FIG. 1 shows a circuit diagram of a half-bridge circuit according to an embodiment of this application;
FIG. 2 shows a package diagram of a power semiconductor device according to an embodiment of this application;
FIG. 3 shows a package diagram of another power semiconductor device according to an embodiment of this application;
FIG. 4 shows a package diagram of another power semiconductor device according to an embodiment of this application;
FIG. 5 shows a package diagram of another power semiconductor device according to an embodiment of this application;
FIG. 6 shows a circuit diagram of a power semiconductor device with a thermistor according to an embodiment of this application;
FIG. 7 shows a package diagram of another power semiconductor device according to an embodiment of this application;
FIG. 8 shows a package diagram of another power semiconductor device according to an embodiment of this application;
FIG. 9 shows a package diagram of another power semiconductor device according to an embodiment of this application;
FIG. 10 shows a circuit diagram of another power semiconductor device with a thermistor according to an embodiment of this application;
FIG. 11 shows a package diagram of another power semiconductor device according to an embodiment of this application;
FIG. 12 shows a circuit diagram of another power semiconductor device with a thermistor according to an embodiment of this application;
FIG. 13 shows a package diagram of another power semiconductor device according to an embodiment of this application;
FIG. 14 shows a package diagram of another power semiconductor device according to an embodiment of this application;
FIG. 15 shows a package diagram of another power semiconductor device according to an embodiment of this application;
FIG. 16 shows a package diagram of another power semiconductor device according to an embodiment of this application;
FIG. 17 shows a package diagram of another power semiconductor device according to an embodiment of this application;
FIG. 18 shows a diagram of a top heat sink with an SOP surface-mount pin according to an embodiment of this application;
FIG. 19 shows a diagram of a top heat sink with a DIP through-hole pin according to an embodiment of this application;
FIG. 20 shows a diagram of a top heat sink with a PLCC surface-mount pin according to an embodiment of this application; and
FIG. 21 shows a diagram of a top heat sink with an SOJ surface-mount pin according to an embodiment of this application.

### DESCRIPTION OF EMBODIMENTS

In following descriptions, numerous specific details are set forth to provide a more thorough understanding of this application. However, it will be apparent to the person skilled in the art that this application can be implemented without one or more of these details. In other examples, to avoid confusion with this application, some technical features well-known in the art have not been described.

It will be understood that this application can be implemented in various forms and will not be construed as limited to embodiments set forth herein. Conversely, these embodiments are provided so that the disclosure will be thorough and complete, and the scope of this application is fully conveyed to the person skilled in the art. In the accompanying drawings, dimensions and relative sizes of layers and regions may be exaggerated for clarity. Same reference numerals represent the same elements throughout.

It will be understood that when an element or a layer is referred to as "on", "close to", "connected to", or "coupled to" other elements or layers, it may be directly on, close to, connected to, or coupled to other elements or layers, or there may be intermediate elements or layers. Conversely, when an element or a layer is referred to as "directly on", "directly close to", "directly connected to", or "directly coupled to" other elements or layers, there is no intermediate element or layer. It will be understood that although the terms "first", "second", "third", or the like may be used to describe various elements, components, regions, layers, and/or portions, these elements, components, regions, layers, and/or portions will not be limited by these terms. These terms are used only to distinguish one element, component, region, layer, or part from another element, component, region, layer, or part. Therefore, without departing from the teachings of this application, the first element, component, region, layer or part discussed below may be expressed as a second element, component, region, layer or part.

Spatial relational terms such as "under", "below", "lower", "on", "above", "upper", and the like may be used herein for ease of description to describe the relationship of one element or feature shown in the figures and other elements or features. It will be understood that, in addition to orientations shown in the figures, the spatial relationship terms are intended to further include different orientations of a device in use and operation. For example, if the device in the figures is flipped, then the element or feature described as "under" or "below" or "underneath" other elements will be oriented "on" the other elements or features. Therefore, the exemplary terms "below" and "under" can include both up and down orientations. The device may be additionally oriented (rotated by 90 degrees or other orientation) and the spatial descriptive terms used herein are interpreted accordingly.

To fully understand this application, detailed structures are provided in the following description to explain technical solutions proposed in this application. Preferred embodiments of this application are described in detail below. However, in addition to these detailed descriptions, this application may have other implementations.

To enable increasingly flexible application of the power semiconductor device, packaging the power semiconductor device provided in the embodiments of this application is relatively flexible, which facilitates wiring and layout on a circuit board during practical application.

The embodiments of this application do not specifically limit specific application scenarios of the power semiconductor device. For example, the power semiconductor device may be applied to a power system, where the power system may be a photovoltaic power generation system, a wind power system, or an energy storage system. In addition, the power semiconductor device may be further applied to a charging pile of an electric vehicle or a charger or motor driver of an electric vehicle, for example, a charging circuit in the charging pile. Generally, the charging circuit includes a power converter, and the power converter may include a direct current/direct current conversion circuit and an alternating current/direct current conversion circuit (a rectifier circuit). These conversion circuits generally include power semiconductor devices. In addition, the power semiconductor device may further be applied to a power supply of a data center or artificial intelligence (AI).

In addition, the embodiments of this application do not specifically limit a quantity of power transistors included in the power semiconductor device. For example, the power semiconductor device may include one power transistor, or may include two power transistors, or may include more power transistors. The quantity of the power transistors in the power semiconductor device can be set according to actual application scenarios. For example, the power semiconductor device may include a power transistor corresponding to a half-bridge circuit, or may include a power transistor corresponding to a full-bridge circuit. The half-bridge circuit corresponds to at least two power transistors, and the full-bridge circuit corresponds to at least four power transistors.

To help the person skilled in the art better understand the technical solutions according to the embodiments of this application, the following description uses a power semiconductor device corresponding to a half-bridge circuit as an example.

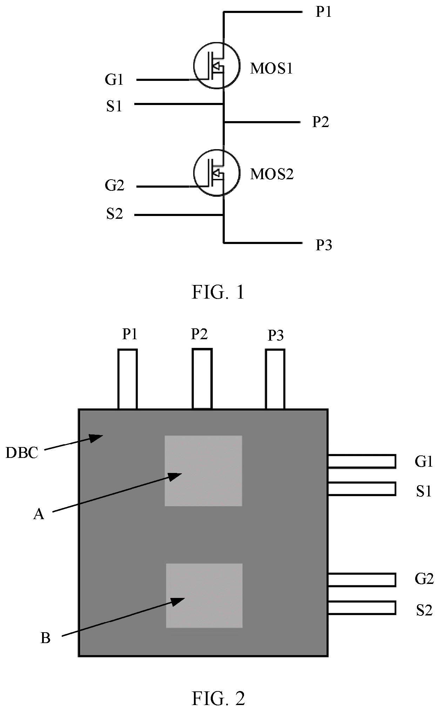

Reference is made to FIG. 1, which is a circuit diagram of a half-bridge circuit according to an embodiment of this application.

This embodiment is described by using an example in which the half-bridge circuit includes two power transistors, that is, the two power transistors are packaged together as a power semiconductor device. It will be understood that the half-bridge circuit may further include two diodes, or may include one diode and one MOS transistor.

FIG. 1 shows an example in which two power transistors are MOS transistors. The first MOS transistor is MOS1, and the second MOS transistor is MOS2.

A drain of MOS1 is connected to a first power pin P1, a source S1 of MOS1 is connected to a drain of MOS2, S1 is connected to a second power pin P2, and a source S2 of MOS2 is connected to a third power pin P3.

A gate G1 of MOS1 and the source S1 of MOS1 are configured to connect to an external control signal, that is, a switching status of MOS1 depends on levels of external signals connected to G1 and S1. Similarly, a switch status of MOS2 depends on levels of external signals connected to G2 and S2.

For packaging of the power semiconductor device corresponding to the half-bridge circuit, corresponding pins include: P1, P2, P3, G1, G2, S1, and S2.

P1, P2, and P3 are power pins. G1, G2, S1, and S2 are all first signal pins.

Reference is made to FIG. 2, which is diagram of a power semiconductor device corresponding to FIG. 1 according to an embodiment of this application.

The power semiconductor device according to this embodiment of this application includes: a substrate, a wafer, a housing, a first signal pin, and a plurality of power pins.

The wafer is disposed on the substrate. The substrate may be implemented as direct bonding copper (DBC). A specific implementation form of the substrate is not specifically limited in this embodiment of this application. This embodiment of this application, using a DBC substrate as an example for description, is merely for ease of description and ease of understanding by the person skilled in the art.

This embodiment of this application is described by using the power semiconductor device corresponding to the half-bridge circuit as an example. Therefore, two power transistors are included, and each power transistor corresponds to at least one wafer. For example, the power semiconductor device according to this embodiment includes two wafers, that is, a wafer A and a wafer B as shown in FIG. 2. The wafer A corresponds to MOS1 in FIG. 1, and the wafer B corresponds to MOS2 in FIG. 1. Each power transistor includes a corresponding power pin and a corresponding signal pin.

It will be understood that each power transistor may correspond to at least one wafer. In this embodiment of this application, only an example in which one power transistor corresponds to one wafer is used for description. In addition, each power transistor may correspond to a plurality of wafers, and the plurality of wafers may be connected in series or in parallel, which is not specifically limited in this embodiment of this application.

Because the wafer A and the wafer B are conductors, and the substrate may be made of a copper material and may also be a conductor, the wafer A and the wafer B may be directly welded to the DBC substrate.

To avoid a short circuit between the wafer A and the wafer B, the wafer A and the wafer B need to be insulated from each other by using an insulating tape.

The power pin and the first signal pin are electrically connected to the substrate. This embodiment corresponds to two power transistors, and the two power transistors correspond to three power pins. That is, the power pins P1, P2, and P3 may all be welded to the DBC substrate. The first signal pins S1, S2, G1, and G2 may alternatively be directly welded to the DBC substrate.

It can be seen from FIG. 2 that P1, P2, and P3 are disposed on the same side of the DBC substrate, and S1, S2, G1, and G2 are disposed on another side of the DBC substrate.

In a conventional power semiconductor device, power pins are distributed on different side surfaces of a substrate, and the power pins and first signal pins or a part of first signal pins are distributed on the same side surface, so that in practical application, a power trace and a first-type signal trace cross or are relatively close to each other, resulting in mutual interference between the power trace and the first-type signal trace.

In the power semiconductor device according to this embodiment of this application, the plurality of power pins are disposed on the same side surface of the substrate, and the first signal pins and the power pins are disposed on the different side surfaces of the substrate, so that a power trace and a first-type signal trace can be separated, avoiding crossed traces, and there is no mutual interference between the power trace and the first-type signal trace.

Generally, the power semiconductor device further includes a housing, and the housing packages the wafer and the substrate. The housing may be made of a plastic material, which is also referred to as a plastic package 10.

In some embodiments of this application, the plurality of power pins are disposed on a first side surface of the substrate, the first signal pins are disposed on a second side surface of the substrate, and the first side surface is disposed adjacent or opposite to the second side surface.

As shown in FIG. 2, the power semiconductor device includes power pins (P1, P2, and P3) and first signal pins (S1, S2, G1, and G2), where P1, P2, and P3 are disposed on the first side surface of the substrate, S1, S2, G1, and G2 are disposed on the second side surface of the substrate, and the first side surface is disposed adjacent to the second side surface.

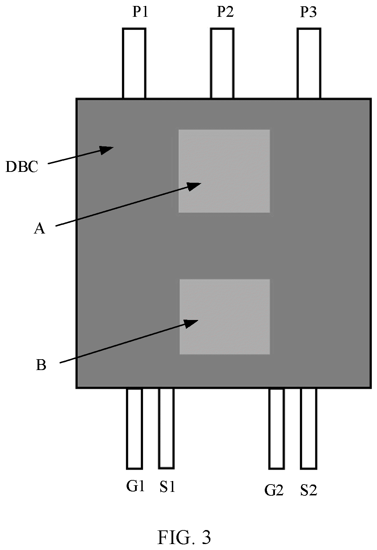

As shown in FIG. 3, the power semiconductor device includes power pins (P1, P2, and P3) and first signal pins (S1, S2, G1, and G2), where P1, P2, and P3 are disposed on the first side surface of the substrate, S1, S2, G1, and G2 are disposed on the second side surface of the substrate, and the first side surface is disposed opposite to the second side surface.

In some embodiments of this application, a plurality of first signal pins are included, and the plurality of first signal pins may be disposed on at least two side surfaces of the substrate.

For example, the plurality of power pins are disposed on the first side surface of the substrate; and a part of the first signal pins are disposed on the second side surface of the substrate, and the remaining part of the first signal pins are disposed on a third side surface of the substrate, wherein the second side surface and the third side surface are disposed adjacent to the first side surface.

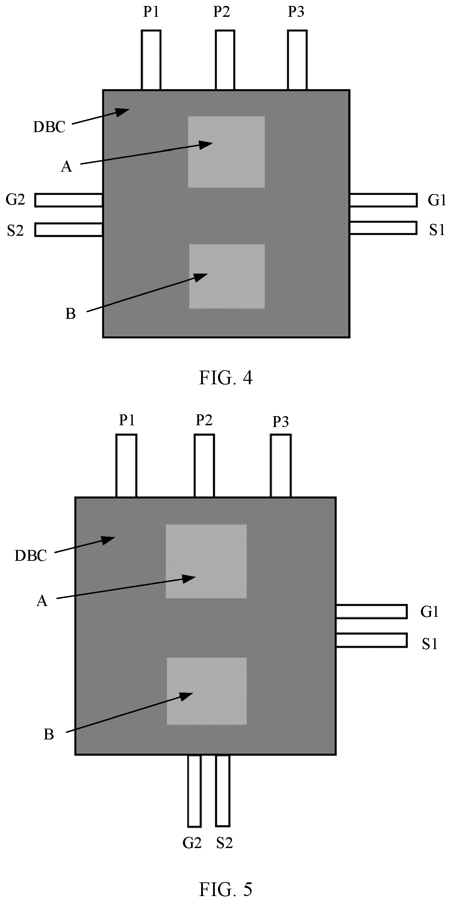

As shown in FIG. 4, the power semiconductor device includes power pins (P1, P2, and P3) and first signal pins (S1, S2, G1, and G2), where P1, P2, and P3 are disposed on the first side surface of the substrate, S1, and G1 are disposed on the second side surface of the substrate, S2 and G2 are disposed on the third side surface of the substrate, and the second side surface and the third side surface are disposed adjacent to the first side surface.

For example, the plurality of power pins are disposed on the first side surface of the substrate; and a part of the first signal pins are disposed on the second side surface of the substrate, and the remaining part of the first signal pins are disposed on the third side surface of the substrate, where the second side surface is disposed adjacent to the first side surface, and the third side surface is disposed opposite to the first side surface.

As shown in FIG. 5, the power semiconductor device includes power pins (P1, P2, and P3) and first signal pins (S1, S2, G1, and G2), where P1, P2, and P3 are disposed on the first side surface of the substrate, S1, and G1 are disposed on the second side surface of the substrate, S2 and G2 are disposed on the third side surface of the substrate, the second side surface is disposed adjacent to the first side surface, and the third side surface is disposed opposite to the first side surface.

Certainly, this application does not exclude the following situations: the plurality of power pins are disposed on the first side surface of the substrate; and a first part of the first signal pins are disposed on the second side surface of the substrate, a second part of the first signal pins are disposed on the third side surface of the substrate, and the remaining part of the first signal pins are disposed on a fourth side surface of the substrate, wherein the second side surface and the third side surface are disposed adjacent to the first side surface, and the fourth side surface is disposed opposite to the first side surface.

Because the power semiconductor device generates heat during operation, for safety of the power semiconductor device, a temperature of the power semiconductor device needs to be detected. The power semiconductor device according to the embodiments of this application may be provided with a temperature sensor in a package of the device. For example, a thermistor is used to implement temperature detection. When the temperature of the power semiconductor device rises too high, the power semiconductor device can be protected in time.

In some embodiments of this application, the power semiconductor device further includes a temperature sensor, and the temperature sensor is disposed on the substrate.

For example, the power semiconductor device includes a thermistor. The thermistor is disposed on the substrate, and two ends of thermistor are respectively electrically connected to second signal pins.

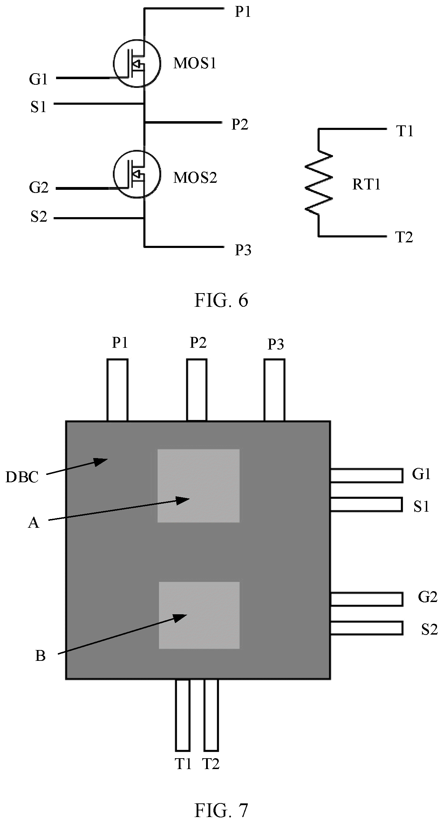

As shown in FIG. 6, compared with FIG. 1, a thermistor RT1 is provided in the power semiconductor device. Two ends of thermistor RT1 are electrically connected to second signal pins T1 and T2. Corresponding temperature data can be obtained by measuring signals from the second signal pins T1 and T2.

In some examples, the second signal pins and the power pins are disposed on different side surfaces of the substrate.

For example, the second signal pins and the first signal pins are disposed on different side surfaces of the substrate. The first signal pins may be disposed on the same side surface or different side surfaces of the substrate. For details, reference is made to configurations of the foregoing first signal pins, which will not be repeated here.

As shown in FIG. 7, the power semiconductor device includes power pins (P1, P2, and P3), first signal pins (S1, S2, G1, and G2), and second signal pins (T1 and T2), where P1, P2, and P3 are disposed on the first side surface of the substrate, S1, S2, G1, and G2 are disposed on the second side surface of the substrate, T1 and T2 are disposed on the third side surface of the substrate, the second side surface is disposed adjacent to the third side surface.

Certainly, this application does not exclude a case in which the second side surface is disposed opposite to the third side surface in FIG. 7.

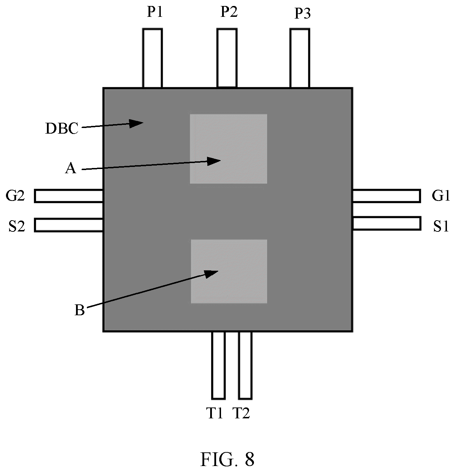

As shown in FIG. 8, the power semiconductor device includes power pins (P1, P2, and P3), first signal pins (S1, S2, G1, and G2), and second signal pins (T1 and T2), where P1, P2, and P3 are disposed on the first side surface of the substrate, S1 and G1 are disposed on the second side surface of the substrate, S2 and G2 are disposed on the third side surface of the substrate, T1 and T2 are disposed on the fourth side surface of the substrate, the second side surface is disposed opposite to the third side surface, and the fourth side surface is disposed opposite to the first side surface.

Certainly, this application does not exclude a case in FIG. 8 in which the second side surface is disposed adjacent to the third side surface, and the fourth side surface is disposed adjacent to the first side surface.

For example, the second signal pins and a part of the first signal pins are disposed on the same side surface of the substrate.

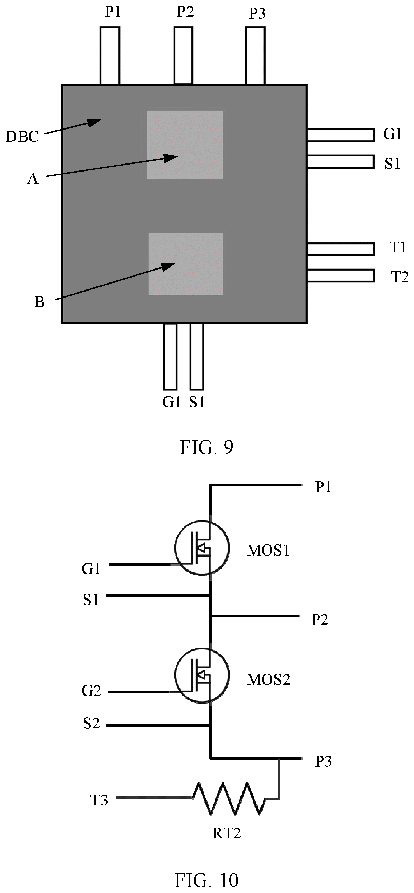

As shown in FIG. 9, the power semiconductor device includes power pins (P1, P2, and P3), first signal pins (S1, S2, G1, and G2), and second signal pins (T1 and T2), where P1, P2, and P3 are disposed on the first side surface of the substrate, S1, G1, T1, and T2 are disposed on the second side surface of the substrate, S2 and G2 are disposed on the third side surface of the substrate, and the second side surface is disposed adjacent to the third side surface.

Certainly, this application does not exclude a case in FIG. 9 in which the second side surface is disposed opposite to the third side surface, and this application does not exclude a case in which T1, T2, and all the first signal pins are disposed on the same side surface.

For example, the power semiconductor device includes a thermistor. The thermistor is disposed on the substrate, one end of the thermistor is electrically connected to a third signal pin, and the other end of the thermistor is electrically connected to one of the power pins.

As shown in FIG. 10, compared with FIG. 1, a thermistor RT2 is provided in the power semiconductor device. One end of the thermistor RT2 is electrically connected to a third signal pin T3, and the other end of the thermistor RT2 is electrically connected to a power pin P3. By measuring a signal from the third signal pin T3, corresponding temperature data can be obtained.

In some examples, the third signal pin and the power pins are disposed on the same side surface of the substrate. The first signal pins can be disposed on the same side surface or different side surfaces of the substrate. For details, reference is made to configurations of the foregoing first signal pins, which will not be repeated here.

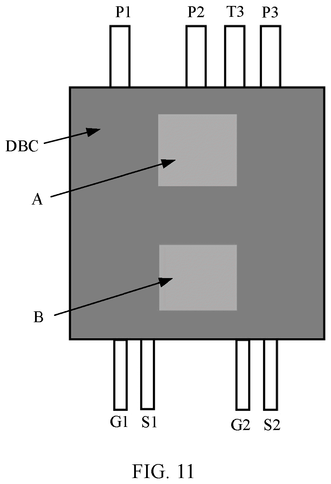

As shown in FIG. 11, the power semiconductor device includes power pins (P1, P2, and P3), first signal pins (S1, S2, G1, and G2), and a third signal pin T3, where P1, P2, P3, and T3 are disposed on the first side surface of the substrate, S1, S2, G1, and G2 are disposed on the second side surface of the substrate, and the first side surface is disposed opposite to the second side surface.

Certainly, this application does not exclude a case in FIG. 11 in which there may be other configurations for the first signal pins S1, S2, G1, and G2.

For example, the power semiconductor device includes two thermistors, namely a first thermistor and a second thermistor. Two ends of the first thermistor are respectively electrically connected to second signal pins. One end of the second thermistor is electrically connected to a third signal pin and the other end of the second thermistor is electrically connected to one of the power pins.

Alternatively, the power semiconductor device may further include a larger quantity of thermistors, which is not additionally repeated here.

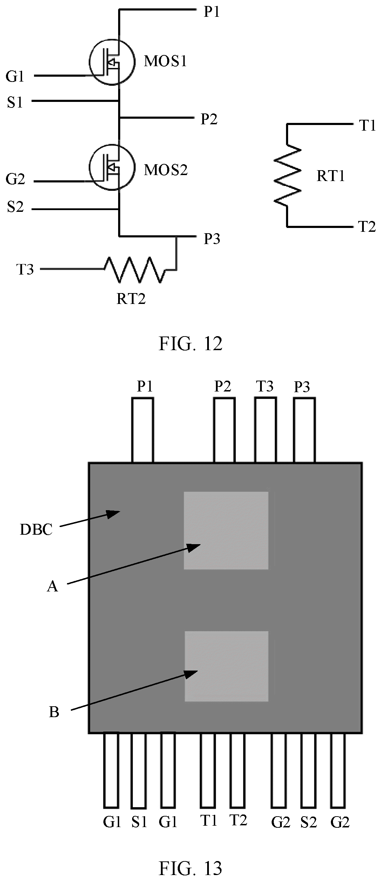

As shown in FIG. 12, compared with FIG. 1, a thermistor RT1 and a thermistor RT2 are provided in the power semiconductor device. Two ends of the thermistor RT1 are respectively electrically connected to second signal pins T1 and T2. One end of the thermistor RT2 is electrically connected to a third signal pin T3, and the other end of the thermistor RT2 is electrically connected to a power pin P3. By measuring signals from the second signal pins T1 and T2 and the third signal pin T3, corresponding temperature data can be obtained.

In some embodiments of this application, the plurality of power pins and the third signal pin are disposed on the first side surface of the substrate, the first signal pins and the second signal pins are disposed on the second side surface of the substrate, and the first side surface is disposed adjacent or opposite to the second side surface.

As shown in FIG. 13, the power semiconductor device includes power pins (P1, P2, and P3), first signal pins (S1, S2, two G1s, and two G2s), second signal pins (T1 and T2), and a third signal pin T3, where P1, P2, P3, and T3 are disposed on the first side surface of the substrate, S1, S2, two G1s, two G2s, T1, and T2 are disposed on the second side surface of the substrate, and the first side surface is disposed opposite to the second side surface.

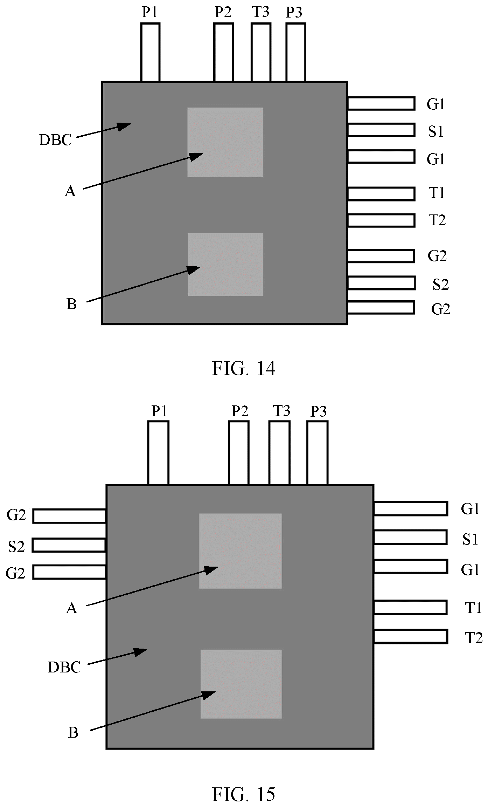

As shown in FIG. 14, the power semiconductor device includes power pins (P1, P2, and P3), first signal pins (S1, S2, two G1s, and two G2s), second signal pins (T1 and T2), and a third signal pin T3, where P1, P2, P3, and T3 are disposed on the first side surface of the substrate, S1, S2, two G1s, two G2s, T1, and T2 are disposed on the second side surface of the substrate, and the first side surface is disposed adjacent to the second side surface.

In some embodiments of this application, the plurality of power pins and the third signal pin are disposed on the same side surface of the substrate. A plurality of first signal pins are included. The plurality of first signal pins are disposed on at least two side surfaces of the substrate. The second signal pins are disposed on at least one side surface on which the first signal pin is provided.

For example, the plurality of power pins and the third signal pin are disposed on the first side surface of the substrate. A part of the first signal pins are disposed on the second side surface of the substrate, and the remaining part of the first signal pins are disposed on the third side surface of the substrate. The third signal pin is disposed on the second side surface or the third side surface, where the second side surface and the third side surface are disposed adjacent to the first side surface.

As shown in FIG. 15, the power semiconductor device includes power pins (P1, P2, and P3), first signal pins (S1, S2, two G1s, and two G2s), second signal pins (T1 and T2), and a third signal pin T3, where P1, P2, P3, and T3 are disposed on the first side surface of the substrate, S1 and two G1s are disposed on the second side surface of the substrate, S2 and two G2s are disposed on the third side surface of the substrate, T1 and T2 are disposed on the second side surface of the substrate, and the second side surface and the third side surface are disposed adjacent to the first side surface.

For example, the plurality of power pins and the third signal pin are disposed on the first side surface of the substrate. A part of the first signal pins are disposed on the second side surface of the substrate, and the remaining part of the first signal pins are disposed on the third side surface of the substrate. The third signal pin is disposed on the second side surface or the third side surface, where the second side surface is disposed adjacent to the first side surface, and the third side surface is disposed opposite to the first side surface.

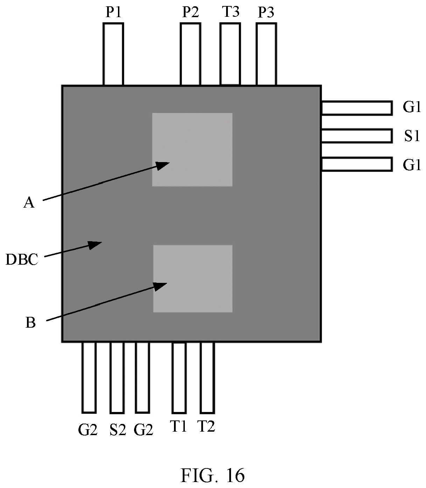

As shown in FIG. 16, the power semiconductor device includes power pins (P1, P2, and P3), first signal pins (S1, S2, two G1s, and two G2s), second signal pins (T1 and T2), and a third signal pin T3, where P1, P2, P3, and T3 are disposed on the first side surface of the substrate, S1 and two G1s are disposed on the second side surface of the substrate, S2 and two G2s are disposed on the third side surface of the substrate, T1 and T2 are disposed on the third side surface of the substrate, and the second side surface is disposed adjacent to the first side surface, and the third side surface is disposed opposite to the first side surface.

For example, the plurality of power pins and the third signal pin are disposed on the first side surface of the substrate. A first part of the first signal pins are disposed on the second side surface of the substrate, a second part of the first signal pins are disposed on the third side surface of the substrate, and the remaining part of the first signal pins is disposed on the fourth side surface of the substrate. The second signal pins are disposed on the fourth side surface, where the second side surface and the third side surface are disposed adjacent to the first side surface, and the fourth side surface is disposed opposite to the first side surface.

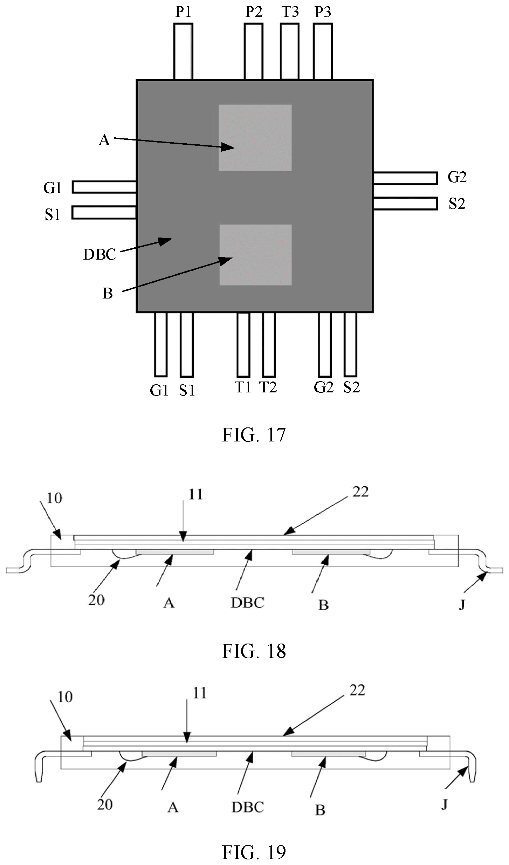

As shown in FIG. 17, the power semiconductor device includes power pins (P1, P2, and P3), first signal pins (two S1s, two S2s, two G1s, and two G2s), second signal pins (T1 and T2), and a third signal pin T3, where P1, P2, P3, and T3 are disposed on the first side surface of the substrate, one S1 and one G1 are disposed on the second side surface of the substrate, one S2 and one G2 are disposed on the third side surface of the substrate, the remaining S1, S2, G1, and G2 are disposed on the fourth side surface of the substrate, and T1 and T2 are disposed on the fourth side surface of the substrate. The second side surface and the third side surface are disposed adjacent to the first side surface, and the fourth side surface is disposed opposite to the first side surface.

In some embodiments of this application, the power pin and the first signal pin include at least one of the following: an SOP surface-mount pin, a DIP through-hole pin, a PLCC through-hole pin, and an SOJ surface-mount pin.

SOP surface-mount pin: SOP is an abbreviation for Small Outline Package. The SOP surface-mount pins are located on two sides of the package, arranged horizontally or vertically. This kind of package has the advantages of small size, excellent electrical performance, and high production efficiency, and therefore, is widely used in modern electronic devices. SOP packages are suitable for various types of electronic components, such as integrated circuits, diodes, transistors, resistors, or capacitors.

DIP through-hole pin: DIP is an abbreviation for Double In-line Package. The pins are led out from two sides of the package, and the package is made of plastic and ceramic. DIP is the most popular plug-in package, which can be used in a standard logic IC, a memory LSI, a microcomputer circuit, or the like.

PLCC through-hole pin: PLCC is an abbreviation for Plastic Leaded Chip Carrier, namely plastic J-lead chip package. The package is a 32-pin package having a square shape, where pins are on all sides, and an overall size of the package is much smaller than that of the DIP package. This type of package is mainly used for packaging integrated circuits.

SOJ surface-mount pin: SOJ is an abbreviation for Small Outline J-Lead Package. It is a derivative form of SOP with a J-type lead that is suitable for use in high-frequency products.

It will be noted that the second signal pin and the third signal pin may alternatively include at least one of the following: an SOP surface-mount pin, a DIP through-hole pin, a PLCC through-hole pin, and an SOJ surface-mount pin.

In a possible implementation, to make a package form of the power semiconductor device more flexible, the power pin and the signal pin may take different pin forms. That is, at least some power pins have a different form from at least some signal pins. All the power pins and all the signal pins may take different forms, or some power pins and all the signal pins may take the same form, or some power pins and some signal pins may take the same form but others are different.

Various types of pins may be directly welded to a copper substrate. A gate and a source of an MOS transistor are welded from the wafer to the copper substrate in a corresponding pin region through a bonding line 20. A thermistor is also directly welded to the copper substrate. To reduce a package size of the entire power semiconductor device, the signal pins may alternatively be in an SOJ form. The entire power semiconductor device is finally plastic-packaged as a whole to ensure flatness.

Because the power semiconductor device generates heat during operation, heat dissipation is required. The power semiconductor device is generally attached to a heat sink, and the generated heat is dissipated through the heat sink. The heat sink generally dissipates heat through air cooling or water cooling. Generally, the heat sink needs to be insulated from an interior of the power semiconductor device.

The power semiconductor device according to the embodiments of this application may further include: an insulation layer and a heat dissipation surface. A first surface of the insulating layer is attached to a first surface of the substrate, the wafer is welded to a second surface of the substrate, and the second surface of the substrate is disposed opposite to the first surface of the substrate.

The heat dissipation surface is attached to a second surface of the insulating layer, and the second surface of the insulating layer is opposite to the first surface of the insulating layer.

The heat dissipation surface of the power semiconductor device according to the embodiments of this application may be located at the top, or may be located at the bottom, which is not specifically limited.

To make the person skilled in the art better understand the technical solutions according to the embodiments of this application, several common forms of pins of chip packages are described below in conjunction with accompanying drawings.

Reference is made to FIG. 18, which is a diagram of a top heat sink with a pin in an SOP surface-mount form according to an embodiment of this application.

A lead J shown in FIG. 18 is in an SOP surface-mount form and a heat dissipation surface 22 is located on the top of the package.

Reference is made to FIG. 19, which is a diagram of a top heat sink with a pin in a DIP through-hole form according to an embodiment of this application.

A lead J shown in FIG. 19 is in a DIP through-hole form and a heat dissipation surface 22 is located on the top of the package.

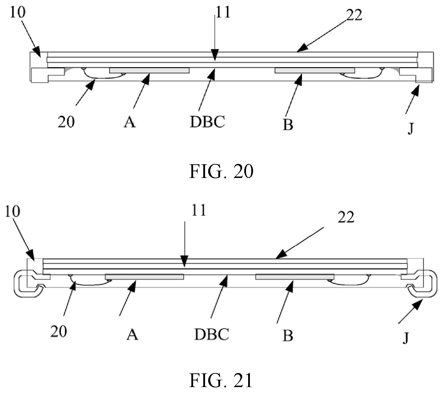

Reference is made to FIG. 20, which is a diagram of a top heat sink with a pin in a PLCC surface-mount form according to an embodiment of this application.

A lead J shown in FIG. 20 is in a PLCC surface-mount form and a heat dissipation surface 22 is located on the top of the package.

Reference is made to FIG. 21, which is a diagram of a top heat sink with a pin in an SOJ surface-mount form according to an embodiment of this application.

A lead J shown in FIG. 21 is in an SOJ surface-mount form and a heat dissipation surface 22 is located on the top of the package.

Moreover, if the power semiconductor device according to the foregoing embodiments is large enough, in addition to internally integrating a temperature sensor, the power semiconductor device may further integrate other detection circuits, for example, a current detection circuit, to implement overcurrent protection. For example, a drive circuit or the like may be integrated internally. In the embodiments of this application, the circuits that may be integrated in the power semiconductor device are not specifically limited, and may be set according to an overall chip size.

It will be understood that a specific implementation form of the power semiconductor device is not specifically limited in the embodiments of this application. For example, the power semiconductor device may include any one of the following: a diode, a thyristor, a metal-oxide-semiconductor field effect transistor (MOSFET), an insulated-gate bipolar transistor (IGBT), silicon carbide (SiC), or gallium nitride (GaN). In addition, a quantity of wafers corresponding to the power semiconductor device is not specifically limited. For example, one power semiconductor device may correspond to one wafer, or one power semiconductor device may correspond to a plurality of wafers, and the plurality of wafers may be connected in series or in parallel.

Based on the power semiconductor device according to the foregoing embodiments, an embodiment of this application further provides a vehicle-mounted charger. Application scenarios of the power semiconductor device are introduced by using the vehicle-mounted charger as an example.

The vehicle-mounted charger may include a power converter, where the power converter may include a rectifier circuit and a direct current/direct current circuit, where the rectifier circuit may include the power semiconductor device described in the foregoing embodiments, and the direct current/direct current circuit may also include the power semiconductor device described in the foregoing embodiments.

An implementation form of the rectifier circuit is not specifically limited in the embodiments of this application, and the rectifier circuit may be a half-bridge circuit or a full-bridge circuit. When the rectifier circuit is a half-bridge circuit, the power semiconductor device corresponding to the half-bridge circuit introduced in the foregoing embodiment may be used. If the rectifier circuit is a full-bridge circuit, the power semiconductor device corresponding to the half-bridge circuit introduced in the foregoing embodiment may also be used. However, the full-bridge circuit needs to use a plurality of power semiconductor devices corresponding to the half-bridge circuit.

Based on the vehicle-mounted charger according to the foregoing embodiments, an embodiment of this application further provides a vehicle, and the vehicle includes the vehicle-mounted charger.

To sum up, in the power semiconductor device, the vehicle-mounted charger, and the vehicle according to the embodiments of this application, the plurality of power pins are disposed on the same side surface of the substrate, and the first signal pins and the power pins are disposed on the different side surfaces of the substrate, so that a power trace and a first-type signal trace can be separated, avoiding crossed traces, and there is no mutual interference between the power trace and the first-type signal trace.

Although example embodiments have been described herein with reference to the accompanying drawings, it will be understood that the foregoing example embodiments are merely illustrative and are not intended to limit the scope of this application thereto. The person of ordinary skill in the art can make various changes and modifications to this application without departing from the scope and the spirit of this application. All these changes and modifications are intended to be included within the scope of this application as claimed in the appended claims.

Similarly, it will be understood that to simplify this application and to aid in understanding one or more of various application aspects, various features of this application are sometimes grouped together in a single embodiment, figure, or description thereof in description of the example embodiments of this application. However, a method in this application will not be construed as reflecting an intention that the claimed application requires more features than those expressly recited in each claim. More specifically, as reflected in the corresponding claims, a point of application is that a corresponding technical problem can be resolved by using features that are fewer than all features of a single disclosed embodiment. Therefore, the claims following specific implementations are hereby expressly incorporated into these specific implementations, where each claim stands as an independent embodiment of this application.

In addition, the person skilled in the art may understand that although some embodiments described herein include certain features included in other embodiments but not others, combinations of features of different embodiments are meant to fall within the scope of this application and form different embodiments. For example, in the claims, any of the claimed embodiments can be used in any combination.

It will be noted that the foregoing embodiments illustrate this application rather than impose any limitation on this application and that the person skilled in the art may design alternative embodiments without departing from the scope of the appended claims. In the claims, any reference sign placed between parentheses will not be construed as a limitation on the claims. Use of words "first", "second", "third", or the like does not indicate any order. These words can be interpreted as names.

## Claims

1. A power semiconductor device, the power semiconductor device comprising: a substrate, a first signal pin, and a plurality of power pins; and
the first signal pin and the power pins are electrically connected to the substrate,
wherein the plurality of power pins are disposed on the same side surface of the substrate, and the first signal pin and the power pins are disposed on different side surfaces of the substrate.

2. The power semiconductor device according to claim 1, wherein the plurality of power pins are disposed on a first side surface of the substrate, the first signal pin is disposed on a second side surface of the substrate, and the first side surface is disposed adjacent or opposite to the second side surface.

3. The power semiconductor device according to claim 1 or 2, wherein a plurality of first signal pins are provided, and the plurality of first signal pins are disposed on at least two side surfaces of the substrate.

4. The power semiconductor device according to claim 3, wherein the plurality of power pins are disposed on the first side surface of the substrate; and
a part of the first signal pins are disposed on the second side surface of the substrate, and the remaining part of the first signal pins are disposed on a third side surface of the substrate,
wherein the second side surface and the third side surface are disposed adjacent to the first side surface, or the second side surface is disposed adjacent to the first side surface and the third side surface is disposed opposite to the first side surface.

5. The power semiconductor device according to claim 3, wherein the plurality of power pins are disposed on the first side surface of the substrate; and
a first part of the first signal pins are disposed on the second side surface of the substrate, a second part of the first signal pins are disposed on a third side surface of the substrate, and the remaining part of the first signal pins are disposed on a fourth side surface of the substrate,
wherein the second side surface and the third side surface are disposed adjacent to the first side surface, and the fourth side surface is disposed opposite to the first side surface.

6. The power semiconductor device according to any one of claims 1 to 5, the power semiconductor device further comprising a temperature sensor, and the temperature sensor being disposed on the substrate.

7. The power semiconductor device according to claim 6, wherein the temperature sensor comprises a first thermistor and/or a second thermistor, two ends of the first thermistor are respectively electrically connected to second signal pins, one end of the second thermistor is electrically connected to a third signal pin, and the other end of the second thermistor is electrically connected to one of the power pins.

8. The power semiconductor device according to claim 7, wherein the second signal pins and the power pins are disposed on different side surfaces of the substrate.

9. The power semiconductor device according to claim 8, wherein the second signal pins and the first signal pins are disposed on different side surfaces of the substrate, or the second signal pins and at least a part of the first signal pins are disposed on the same side surface of the substrate.

10. The power semiconductor device according to any one of claims 7 to 9, wherein the third signal pin and the power pins are disposed on the same side surface of the substrate.

11. The power semiconductor device according to any one of claims 7 to 9, wherein the plurality of power pins and the third signal pin are disposed on the first side surface of the substrate, the first signal pins and the second signal pins are disposed on the second side surface of the substrate, and the first side surface is disposed adjacent or opposite to the second side surface.

12. The power semiconductor device according to any one of claims 7 to 9, wherein the plurality of power pins and the third signal pin are disposed on the same side surface of the substrate; and
a plurality of first signal pins are provided, the plurality of first signal pins are disposed on at least two side surfaces of the substrate, and the second signal pins are disposed on at least one side surface on which the first signal pin is provided.

13. The power semiconductor device according to claim 12, wherein the plurality of power pins and the third signal pin are disposed on the first side surface of the substrate;
a part of the first signal pins is disposed on the second side surface of the substrate, and the remaining part of the first signal pins is disposed on the third side surface of the substrate; and
the third signal pin is disposed on the second side surface or the third side surface,
wherein the second side surface and the third side surface are disposed adjacent to the first side surface, or the second side surface is disposed adjacent to the first side surface and the third side surface is disposed opposite to the first side surface.

14. The power semiconductor device according to claim 12, wherein the plurality of power pins and the third signal pin are disposed on the first side surface of the substrate;
a first part of the first signal pins are disposed on the second side surface of the substrate, a second part of the first signal pins are disposed on the third side surface of the substrate, and the remaining part of the first signal pins are disposed on the fourth side surface of the substrate; and
the second signal pins are disposed on the fourth side surface,
wherein the second side surface and the third side surface are disposed adjacent to the first side surface, and the fourth side surface is disposed opposite to the first side surface.

15. The power semiconductor device according to any one of claims 1 to 14, wherein the power semiconductor device comprises any one of the following: a diode, a thyristor, a metal-oxide-semiconductor field effect transistor, an insulated-gate bipolar transistor, silicon carbide, or gallium nitride.

16. The power semiconductor device according to any one of claims 1 to 15, wherein both the power pin and the first signal pin comprise at least one of the following:
an SOP surface-mount pin, a DIP through-hole pin, a PLCC through-hole pin, and an SOJ surface-mount pin.

17. The power semiconductor device according to any one of claims 1 to 16, the power semiconductor device further comprising a housing and a wafer, the wafer being disposed on the substrate, and the housing encapsulating the wafer and the substrate.

18. A vehicle-mounted charger, comprising the power semiconductor device according to any one of claims 1 to 17.

19. A vehicle, comprising the vehicle-mounted charger according to claim 18.
